# FASCICULE DE BREVET EUROPEEN

(11) **EP 1 272 350 B1**
(45) Date de publication et mention de la délivrance du brevet: **26.11.2003**
(21) Numéro de dépôt: 01925619.7
(22) Date de dépôt: 11.04.2001
(51) Int. Cl.: B41J 2/345, B41J 2/43, B41J 2/44, B41J 2/447, B41J 2/455, B41J 2/46, B41J 2/505, H01L 27/15, H01L 27/22

(54) **STRUCTURE D'ELEMENTS A HAUTE DENSITE FORMEE PAR ASSEMBLAGE DE COUCHES ET SON PROCEDE DE FABRICATION**
ANORDNUNG VON BAUTEILEN MIT HOHER DICHTE BESTEHEND AUS MEHREREN SCHICHTEN UND HERSTELLUNGSVERFAHREN
HIGH DENSITY ELEMENT STRUCTURE FORMED BY ASSEMBLY OF LAYERS AND METHOD FOR MAKING SAME

(30) Priorité: 11.04.2000 FR 0004617
(43) Date de publication de la demande: 08.01.2003
(73) Titulaire: COMMISSARIAT A L'ENERGIE ATOMIQUE, 75015 Paris Cédex 15 (FR)
(72) Inventeur: BALERAS, François, F-38170 Seyssinet (FR); POUPON, Gilles, F-38170 Seyssinet-Pariset (FR); ASPAR, Bernard, F-38140 Rives (FR)
(74) Mandataire: Ilgart, Jean-Christophe
(86) Numéro de dépôt international: FR0101116
(87) Numéro de publication internationale: WO01076879

(56) Documents cités:
- EP-A- 0 335 473
- EP-A- 0 493 055
- US-A- 4 590 492
- US-A- 4 651 168
- US-A- 5 300 788
- US-A- 5 402 436
- US-A- 5 485 193
- US-A- 5 624 708
- PATENT ABSTRACTS OF JAPAN vol. 009, no. 187 (M-401), 3 août 1985 (1985-08-03) -& JP 60 054866 A (HITACHI SEISAKUSHO), 29 mars 1985 (1985-03-29)
- PATENT ABSTRACTS OF JAPAN vol. 013, no. 118 (M-806), 23 mars 1989 (1989-03-23) -& JP 63 290767 A (MATSUSHITA ELECTRIC), 28 novembre 1988 (1988-11-28)

## Description

### Domaine technique et art antérieur

L'invention concerne une structure comprenant une succession d'éléments destinés à émettre ou à recevoir un signal le long d'un axe.

L'invention s'applique avantageusement au cas où les éléments destinés à émettre ou à recevoir le signal doivent atteindre une haute densité. Il peut s'agir, par exemple, de réseaux de composants optiques (diodes laser, fibres optiques, détecteurs), de réseaux d'antennes, de têtes d'impression, etc..

A titre d'exemple non limitatif, l'invention sera plus particulièrement décrite dans le cas d'une tête d'impression.

Une technique d'impression connue est l'impression à l'aide de barrettes. Chaque barrette comprend des éléments alignés côte à côte. Chaque élément est soit une tête magnétique, soit une résistance, selon que le signal d'impression est magnétostatique ou thermique. Une ou plusieurs barrettes mises bout à bout forment une ligne de la largeur du support à imprimer.

Le support qui reçoit l'impression défile par rapport aux barrettes qui transforment les signaux électriques d'écriture reçus soit en signaux magnétiques, soit en signaux thermiques. L'impression du support s'effectue ligne par ligne par défilement relatif du support ou des barrettes. Chaque élément reçoit un signal d'écriture qui se renouvelle à chaque ligne à imprimer.

Plusieurs procédés de fabrication de tête d'impression sont connus de l'art antérieur.

Une première technique connue consiste à assembler des têtes d'impression individuelles. Une tête d'impression individuelle peut comporter, par exemple, une tête magnétique commandée par une diode ou un transistor. La tête magnétique est réalisée sur un support mécanique et la diode de commande est soudée sur le support. Les têtes d'impression individuelles sont alors montées sur un support mécanique avec un interposeur entre les têtes.

Cette méthode de fabrication limite la résolution de la tête d'impression à des valeurs comprises entre 150 et 300 dpi (dpi pour "dot per inch" ).

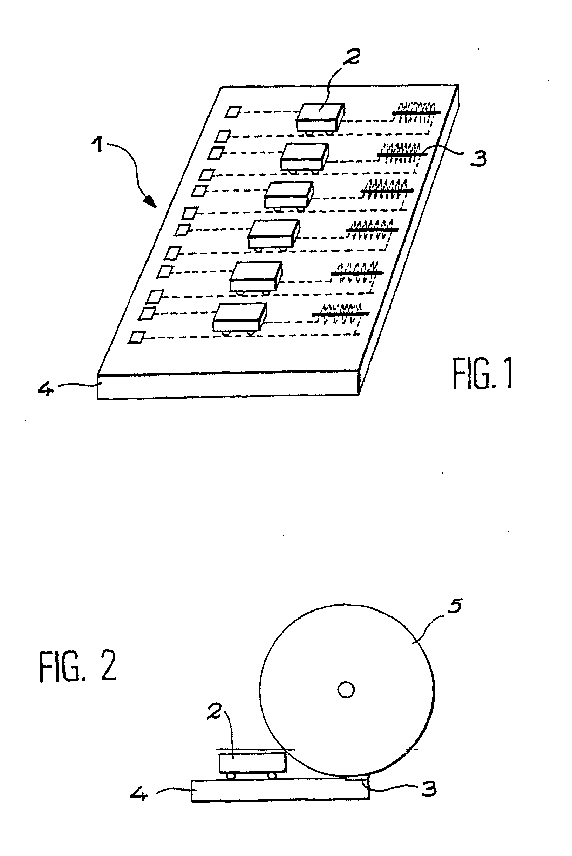

Une deuxième méthode de fabrication est liée aux techniques de la micro-électronique. Les têtes d'impression sont alors réalisées de façon collective sur un substrat semi-conducteur. Un exemple de structure collective de têtes d'impression obtenue selon cette deuxième méthode est représentée en figure 1.

La tête d'impression 1 est constituée d'un ensemble de têtes magnétiques individuelles 3 réalisées sur un substrat semi-conducteur 4. Chaque tête magnétique individuelle 3 est commandée par une diode 2. Les diodes 2 peuvent être intégrées ou rapportées sur le substrat semi-conducteur 4.

Cette deuxième technique de fabrication permet d'atteindre des résolutions de l'ordre de 600 dpi. Cependant, de telles résolutions ne peuvent être atteintes qu'à l'aide d'une réduction de la taille des têtes magnétiques. De façon désavantageuse il en résulte une diminution de l'intensité du champ magnétique induit par les têtes magnétiques.

Cette technique présente également d'autres inconvénients.

Comme représenté en figure 2, le tambour 5 de l'imprimante vient au contact des têtes magnétiques 3. Dans le cas où les diodes 2 sont rapportées sur le substrat 4, il est alors nécessaire d'éloigner les diodes 2 des têtes 3 afin d'éviter que le tambour ne vienne au contact des diodes. La zone située entre les diodes 2 et les têtes 3 est alors perdue. La longueur de la ligne qui sépare une diode 2 d'une tête magnétique 3 peut alors présenter une résistance électrique susceptible de réduire les performances de la tête magnétique.

Dans le cas où les diodes 2 sont intégrées au substrat 4, l'inconvénient mentionné ci-dessus n'existe pas. Cependant, il est alors nécessaire de mettre en oeuvre deux technologies de fabrication différentes : une pour les diodes, une autre pour les têtes magnétiques. Le rendement de fabrication s'en trouve diminué.

L'invention ne présente pas les inconvénients mentionnés ci-dessus.

### Exposé de l'invention

En effet, l'invention concerne une structure telle que define dans la revendication 1.

L'invention concerne également un procédé de fabrication d'une structure comprenant une succession d'éléments pour émettre ou recevoir un signal le long d'un axe. Le procédé est defini dans la revendication 7.

L'invention permet avantageusement d'obtenir une structure à haute résolution. Il est possible d'atteindre, par exemple, des résolutions de l'ordre de 1200 dpi, voire plus, par reports de couches successifs.

Le procédé selon le mode de réalisation préférentiel de l'invention utilise la technique de transfert de couches (ou multicouches) par adhésion moléculaire à l'échelle du wafer. Cette technique consiste à réaliser sur un premier substrat au moins une couche semi-conductrice comportant des têtes d'impression, puis de transférer, par collage moléculaire, la ou les couches semi-conductrices comportant les têtes d'impression sur un deuxième substrat comportant déjà au moins une couche comportant des têtes d'impression; de façon successive, on peut ainsi augmenter le nombre de niveaux de têtes d'impression de la structure. Le collage moléculaire permet la réalisation des interconnexions par les techniques de la microélectronique (gravure plasma, pulvérisation). Selon les structures réalisées, on peut ramener l'ensemble des entrées/sorties sur une seule face ou sur deux faces. De plus, la technique de transfert de couches est compatible avec le procédé de brasage de billes fusibles.

Cette technique est également compatible avec les méthodes d'amincissement des wafers, ce qui permet de réduire encore les dimensions du module d'impression.

La distance entre deux têtes consécutives peut se réduire à l'épaisseur des couches, ce qui permet d'obtenir un pas vertical équivalent au pas horizontal.

Cette méthode permet aussi l'assemblage de plusieurs fonctionnalités (couches pour les têtes et couches pour les circuits de commande) et de réaliser les interconnexions entre les têtes et les circuits de commande (toujours par les procédés de la microélectronique).

Dans le cas d'un report sur face arrière, l'avantage du report par collage moléculaire permet de réaliser des têtes d'impression sur les deux faces de sorte que les couches de chaque face ne viennent pas en contact des porte-substrats des équipements.

Par rapport aux techniques d'assemblage selon l'art antérieur, la technique d'assemblage par transfert de couches selon le mode de réalisation préférentiel de l'invention permet avantageusement, dans un premier temps, de réaliser un empilement de têtes sur un premier support permettant d'utiliser la précision des technologies de la microélectronique puis, ensuite, de transférer l'empilement de têtes sur un autre support adapté à l'application souhaitée. Le premier support peut être, par exemple, une plaquette de silicium, d'AsGa, de SiC, de SOI ou de InP. Le support adapté à l'application souhaitée peut être, par exemple, un substrat en plastique pour une application de tête d'imprimante à système à tambour (cela permet alors d'éviter la dégradation du substrat dû au frottement du substrat sur le tambour), un substrat en céramique pour une tête utilisant un effet thermique, un circuit imprimé pour connecter un empilement de têtes à d'autres composants tels que des puces de commande, ou encore un circuit imprimé souple.

La technique d'assemblage selon l'invention permet ainsi d'intégrer sur un ou deux supports, selon les variantes, l'intégralité des fonctions (têtes d'impression, circuits de commande et interconnexions) tout en réduisant au minimum les dimensions du module (dimensions globales et distance entre les têtes).

Dans la suite de la description, l'invention sera plus particulièrement décrite dans le cas où la structure est une tête d'impression dont les éléments sont des têtes magnétiques. De façon plus générale, comme cela a été mentionné précédemment, l'invention concerne toute structure comprenant une succession d'éléments pour émettre ou recevoir un signal le long d'un axe : réseau de composants optiques (diodes laser, fibres optiques, détecteurs), réseaux d'antennes, etc..

### Brève description des figures

D'autres caractéristiques et avantages de l'invention apparaîtront à la lecture de modes de réalisation de l'invention fait en référence aux figures ci-annexées parmi lesquelles :
- la figure 1 représente une tête d'impression selon l'art antérieur,
- la figure 2 représente une vue en coupe de la tête d'impression de la figure 1, équipée de son tambour,
- la figure 3 représente une vue en perspective d'un premier mode de réalisation de tête d'impression selon l'invention,
- les figures 4A et 4B représentent respectivement une vue en coupe longitudinale d'une tête d'impression et une vue en coupe transversale d'un substrat comportant les têtes d'impression selon l'invention,
- les figures 5A à 5F représentent un procédé de fabrication de tête d'impression selon le deuxième mode de réalisation représenté aux figures 4A et 4B,
- les figures 6A à 6F représentent différents exemples de tête d'impression selon l'invention.

### Description détaillée de modes de mise en oeuvre de l'invention

Sur toutes les figures, les mêmes repères désignent les mêmes éléments.

Les figures 1 et 2 ont été décrites précédemment, il est donc inutile d'y revenir.

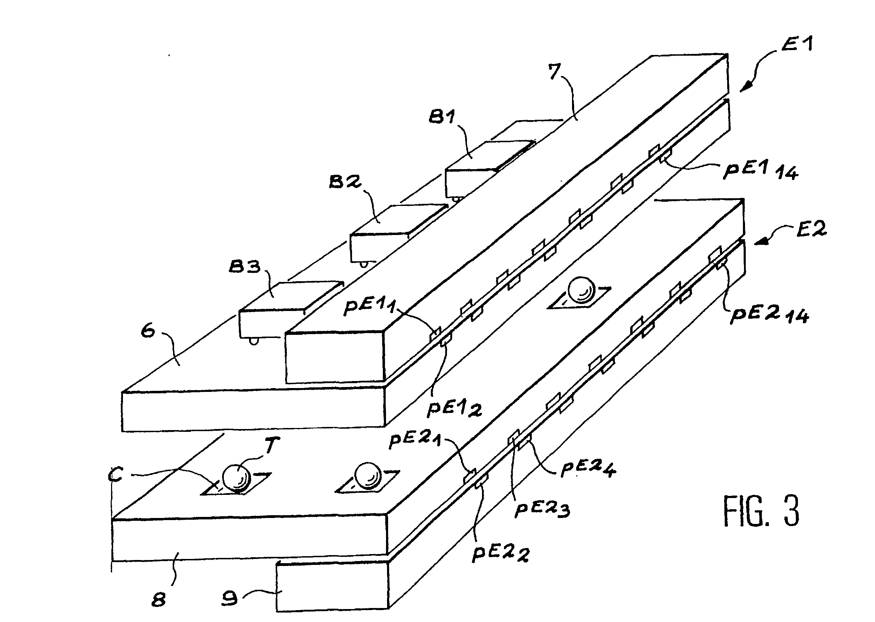

La figure 3 représente une vue en perspective de deux sous-ensembles permettant de réaliser un premier exemple de tête d'impression selon l'invention.

Un premier sous-ensemble E1 comprend une première barrette 6, une deuxième barrette 7, et plusieurs blocs de diodes B1, B2, B3. Un deuxième sous-ensemble E2, identique au premier sous-ensemble E1, comprend une première barrette 8, une deuxième barrette 9 et plusieurs blocs de diodes (non représentés sur la figure).

Les barrettes 6 et 7 du sous-ensemble E1, de même que les barrettes 8 et 9 du sous-ensemble E2, sont fixées l'une à l'autre, par exemple à l'aide de billes de soudure déposées sur des plots d'accrochage. Ces billes de soudure permettent aussi une connexion électrique entre les barrettes 6 et 7 du sous-ensemble E1 et les barrettes 8 et 9 du sous-ensemble E2.

Chaque barrette comprend un ensemble de têtes magnétiques réalisées sur l'une de ses faces. La face sur laquelle sont situées les têtes magnétiques de la barrette 6 est fixée à la face sur laquelle sont situées les têtes magnétiques de la barrette 7. De même, la face sur laquelle sont situées les têtes magnétiques de la barrette 8 est fixée à la face sur laquelle sont situées les têtes magnétiques de la barrette 9.

Pour fixer la barrette 7 (respectivement 9) à la barrette 6 (respectivement 8), la barrette 7 (respectivement 9) est positionnée sur la barrette 6 (respectivement 8) et pendant la phase de refonte des billes de soudure, les pièces s'autoalignent.

Les diodes de commande des têtes magnétiques du premier sous-ensemble E1 sont réalisées par blocs (B1, B2, B3) rapportés sur la face de la barrette 6 sur laquelle sont réalisées les têtes magnétiques. Les diodes des blocs B1, B2, B3 permettent de commander à la fois les têtes magnétiques de la barrette 6 et les têtes magnétiques de la barrette 7.

De même, les diodes de commande des têtes magnétiques du deuxième sous-ensemble E2 sont réalisées par blocs (non représentés sur la figure) rapportés sur la face de la barrette 8 sur laquelle sont réalisées les têtes magnétiques.

Les diodes des blocs ainsi rapportés permettent de commander les têtes magnétiques des barrettes 8 et 9.

Les deux sous-ensembles E1 et E2 sont assemblés entre eux à l'aide d'entretoises T, par exemple des billes rigides, placées dans des cavités C préalablement réalisées sur les faces arrières des barrettes respectives 6 et 8.

Les deux sous-ensembles E1 et E2 sont pressés l'un contre l'autre et alignés. L'espace restant entre les modules peut alors être rempli par de la colle, par exemple de la résine époxy.

L'assemblage des sous-ensembles E1 et E2 peut également être réalisé par des billes fusibles reportées sur des plots d'accrochage. Ces plots d'accrochage sont alors préalablement réalisés sur les faces arrières des barrettes respectives 6 et 8.

La température de refusion des billes utilisées pour l'assemblage des sous-ensembles E1 et E2 est inférieure à celle des billes utilisées pour l'assemblage des barrettes 6 et 7 (respectivement 8 et 9). Pendant la phase de refonte, les deux sous-ensembles s'auto-alignent.

Quel que soit l'empilement réalisé, l'ensemble peut, en fin de procédé, être avantageusement rempli, par exemple, par de la résine pour obtenir un ensemble mécaniquement rigide (il en est de même pour les autres exemples de réalisation).

Les extrémités des têtes magnétiques du sous-ensemble E1 et E2 constituent des pôles magnétiques. A titre d'exemple non limitatif, le sous-ensemble E1 comprend 14 pôles magnétiques pE1₁,..., pE1₁₄ et le sous-ensemble E2 comprend 14 pôles magnétiques pE2₁, ..., pE2₁₄. Selon l'invention, les signaux qui permettent de former une ligne d'impression sur le support sont alors constitués, par exemple, des signaux issus des pôles magnétiques successifs pE1₁, pE2₁, pE1₂, pE2₂, ..., pE1₁₄, pE2₁₄.

La différence de hauteur des pôles dans la direction perpendiculaire à l'axe que définit la ligne d'impression peut être compensée par un système électronique de déphasage temporel.

A titre d'exemple non limitatif, pour un pas des pôles magnétiques conduisant à une résolution de 225 dpi pour une barrette (6, 7, 8 ou 9), on peut obtenir une résolution de 450 dpi pour chaque sous-ensemble E1, E2 en assemblant les barrettes respectives de ces sous-ensembles avec un décalage d'un demi-pas. L'assemblage des deux sous-ensembles E1 et E2 avec un décalage d'un quart de pas conduit alors à une résolution de 900 dpi. Une telle résolution peut encore être augmentée si le pas des pôles magnétiques d'une barrette conduit à une résolution supérieure à 225 dpi. Par exemple, une résolution de 300 dpi pour les barrettes 6, 7, 8 et 9 conduit à une résolution de 1200 dpi (4 × 300 dpi) pour la tête d'impression constituée dés deux sous-ensembles E1 et E2.

Le décalage des pôles magnétiques selon une direction parallèle à l'axe d'impression peut être réalisé de différentes manières. Il est par exemple possible soit de réaliser des barrettes différentes quant à la position des pôles magnétiques et d'assembler symétriquement les barrettes, soit de réaliser des barrettes identiques et d'assembler les barrettes avec un décalage.

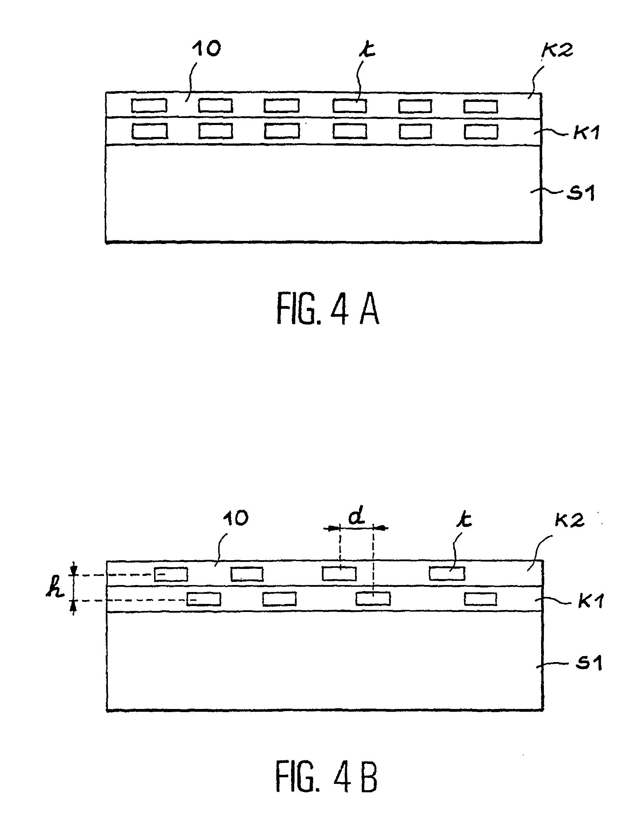

Les figures 4A et 4B représentent, respectivement, une vue en coupe longitudinale d'une tête d'impression et une vue en coupe transversale d'un substrat comportant les têtes d'impression selon l'invention.

Un substrat S1 est recouvert d'une couche K1 qui est elle-même recouverte d'une couche K2. Chaque couche Ki (i=1, 2) est constituée d'un matériau 10 dans lequel sont formées des têtes magnétiques t. L'augmentation de la résolution est obtenue par décalage des têtes magnétiques t (cf. figure 4B). Avantageusement, la distance h qui sépare deux têtes magnétiques successives selon la direction perpendiculaire à l'axe d'impression peut atteindre une valeur de l'ordre de 20 µm à 30 µm. Cette valeur de h peut correspondre sensiblement à la distance minimale d qui sépare deux têtes magnétiques successives de la tête d'impression. Aucune compensation électronique des signaux appliqués aux têtes magnétiques n'est alors nécessaire.

La tête d'impression décrite aux figures 4A et 4B ne comprend que deux couches K1, K2 munies de têtes magnétiques. Il faut cependant noter que, de façon plus générale, l'invention concerne une tête d'impression comprenant au moins deux couches munies de têtes magnétiques

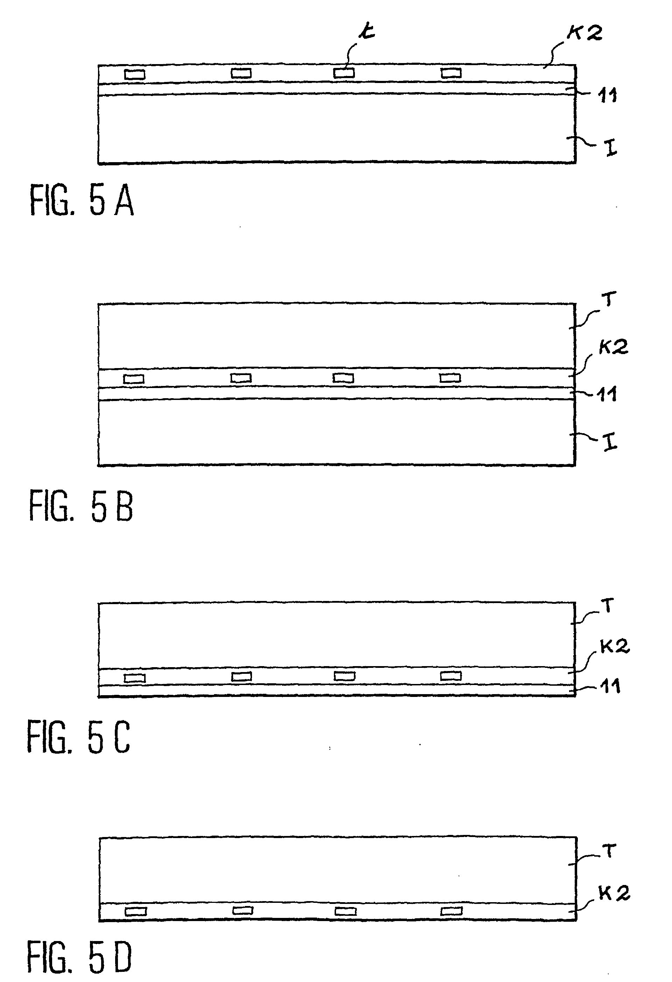

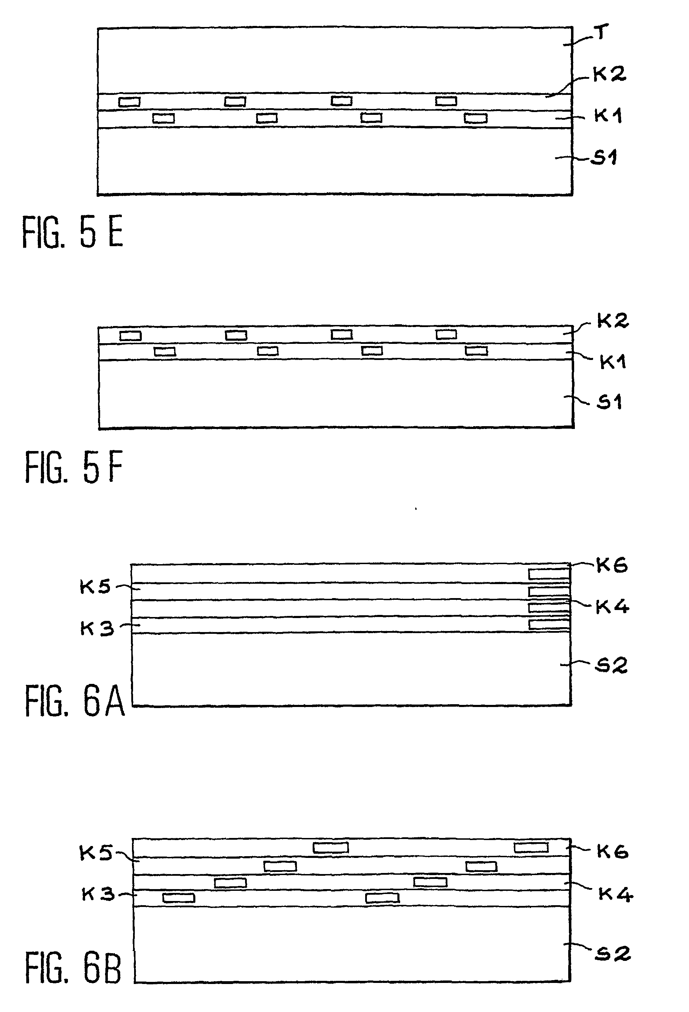

Les figures 5A à 5F représentent un exemple de procédé de fabrication de tête d'impression selon l'invention.

La figure 5A montre une structure constituée d'un substrat initial I sur lequel sont déposées une couche d'arrêt 11 et une couche K2 munie de têtes magnétiques t. Le substrat I permet la formation des couches 11 et K2 selon les technologies de la microélectronique. Le substrat I peut être, par exemple, une plaquette de silicium, d'AsGa, de SiC, de SOI ou de InP. La couche d'arrêt 11 peut être, par exemple, un oxyde de silicium.

A titre d'exemple non limitatif, la structure représentée en figure 5A comprend une couche d'arrêt 11 et une couche K2 munie de têtes magnétiques t. L'invention concerne également le cas où il n'y a pas de couche d'arrêt 11 et/ou le cas où la structure comprend un empilement de plusieurs couches munies de têtes magnétiques.

Le procédé de fabrication d'une tête d'impression à partir d'une structure telle que représentée en figure 5A comprend les étapes suivantes :
- report, par exemple par collage, d'un support de transfert T sur la face libre de la couche K2. Le support de transfert T, communément appelé poignée, peut être réalisé dans une matière transparente, par exemple en verre ou en silice pure, afin d'éviter les problèmes d'alignement (figure 5B),
- retrait du substrat initial I par un procédé classique ou une combinaison de procédés classiques : rectification mécanique, polissage, séparation le long d'un plan de clivage induit par implantation ionique, gravure chimique, réactive, sélective, ou par ultrasons (figure 5C),
- retrait de la couche d'arrêt 11 (figure 5D),
- report de la face libre de la couche K2 sur la face libre d'une couche K1 dont l'autre face est fixée sur un substrat S1 et mise en contact adhérant des deux faces, par exemple par collage ou adhésion moléculaire; pour augmenter l'énergie de collage, des traitements de surface peuvent être effectués sur les surfaces à coller,
- retrait du support de transfert T par l'un des procédés mentionnés ci-dessus en description de la figure 5C (figure 5F)

Le procédé selon l'invention comprend également des étapes de prises de contact électrique sur les têtes magnétiques (ouverture dans les couches de passivation et métallisation). Ces étapes ne sont pas représentées sur les figures.

A titre d'exemple non limitatif, les couches K1 et K2 peuvent être réalisées à partir de matériau semi-conducteur. Le report de la couche K1 sur la couche K2 peut alors être réalisé par la technique d'adhésion moléculaire. L'adhésion moléculaire concerne deux types de collage : le collage hydrophile et le collage hydrophobe. Le collage hydrophile résulte de l'évolution d'interactions -OH à la surface d'une structure vers la formation par exemple de liaisons Si-O-Si. Les forces associées à ce type d'interaction sont fortes. L'énergie de collage, de l'ordre de 100 mJ/m² à température ambiante, atteint 500 mJ/m² après recuit à 400°C pendant 30 minutes (valeurs obtenues pour un collage SiO2 natif ou hydrophile -SiO2 thermique non poli).

L'énergie de collage est généralement déterminée par la méthode de lame divulguée par W.P. MASZARA et al. dans l'article « Bonding of silicon wafers for silicon-on-insulator » paru dans J.Appl.Phy. 64(10), 15 novembre 1988, pages 4943 - 4950. Pour un collage oxyde de silicium déposé et poli - oxyde de silicium déposé et poli, l'énergie de collage est de l'ordre de 1 J/m² pour un recuit sous les mêmes conditions. Par contre, si une surface traitée hydrophile est collée par adhésion moléculaire sur une surface traitée hydrophobe, un collage de très mauvaise qualité est obtenu et les forces de collage sont très faibles : énergie de collage de l'ordre de 100 mJ/m² après recuit à 400°C pendant 30 minutes.

Par cette méthode de collage, il est possible d'assembler deux substrats comportant des technologies de la micro-électronique à condition de préparer leurs états de surface. La précision sur le pas de deux têtes magnétiques successives est avantageusement obtenue par la précision de collage, soit ± de l'ordre de 1 µm aussi bien selon la direction de l'axe d'impression que selon la direction perpendiculaire à l'axe d'impression.

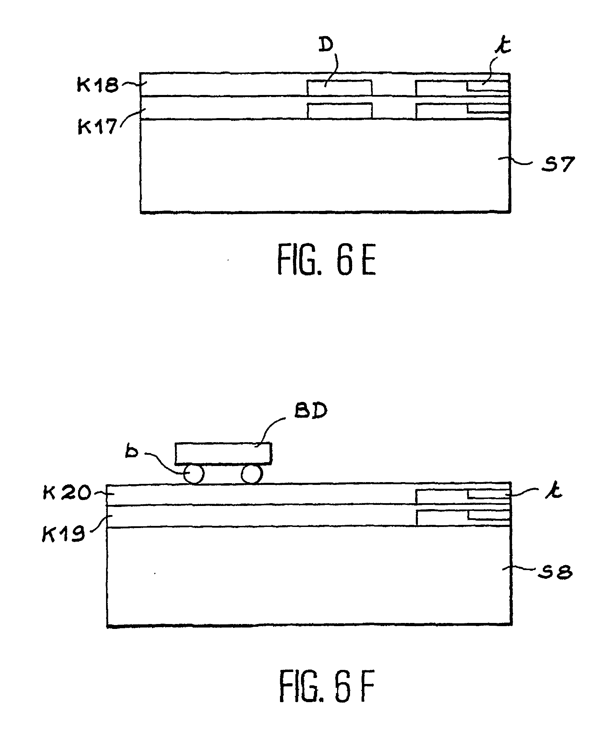

Les figures 6A à 6F représentent différents exemples de têtes d'impression selon l'invention.

Les figures 6A et 6B représentent, respectivement, une vue longitudinale et une vue transversale d'une structure composée d'un substrat S2 sur lequel sont empilées quatre couches successives K3, K4, K5, K6.

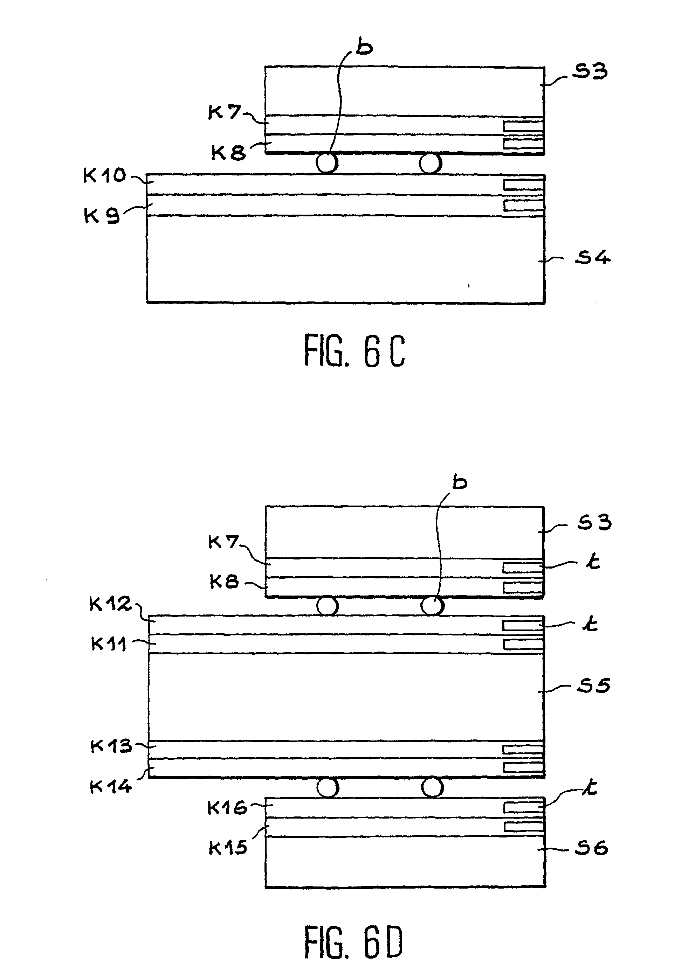

Les figures 6C et 6D représentent deux exemples de têtes d'impression comprenant des structures assemblées à l'aide de connexions par billes de soudure. La connexion par billes de soudure est connu de l'homme de l'art sous la dénomination de montage « flip-chip ».

La figure 6C représente un assemblage de deux structures. Une première structure est constituée d'un substrat S3 sur lequel sont collées deux couches successives K7 et K8. Une deuxième structure est constituée d'un substrat S4 sur lequel sont collées deux couches successives K9 et K10. La connexion par billes de soudure est réalisée entre les faces libres des couches K8 et K10. Une telle structure permet, par exemple, d'atteindre une résolution de l'ordre de 1200 dpi.

La tête d'impression représentée en figure 6D comprend l'association de trois structures. Une première structure est constituée d'un substrat S5 recouvert, sur une première face, de deux couches K13 et K14 et, sur l'autre face, de deux couches K15 et K16. Les deux autres structures sont constituées, chacune, d'un substrat (S3, S6) sur lequel sont collées deux couches (K7 et K8 pour le substrat K3; K15 et K16 pour le substrat S6). Les faces libres des couches K16 et K14, d'une part, et les faces libres des couches K8 et K12, d'autre part, sont assemblées par billes de soudure.

Les figures 6E et 6F représentent deux exemples de tête d'impression selon l'invention incluant les diodes pour la commande des têtes magnétiques.

La figure 6E représente une structure à deux couches K17, K18, chaque couche comprenant un ensemble de diodes D pour la commande des têtes magnétiques qu'elle contient. La figure 6F représente une structure à deux couches K19, K20. Un bloc de diodes BD est connecté par billes de soudure b à la face libre de la couche supérieure K20.

Les figures 6A-6F sont données à titre d'exemples non limitatifs. De façon plus générale, comme cela a été mentionné précédemment, l'invention concerne toute structure comprenant au moins un ensemble constitué d'un substrat de réception sur lequel sont déposées au moins deux couches de matériau munies, chacune, de têtes magnétiques. Les ensembles constitués d'un substrat de réception et de couches de matériau peuvent être reliés entre eux par billes de soudure ou tout autre moyen.

## Revendications

1. Structure comprenant une succession d'éléments (t) pour émettre ou recevoir un signal le long d'un axe, deux éléments (t) successifs dans la direction de l'axe étant décalés, l'un par rapport à l'autre, dans une direction perpendiculaire à l'axe, **caractérisée en ce que** la structure comprend au moins un ensemble d'au moins deux couches de matériau semi-conducteur (K1, K2, K3, K4) déposées sur un substrat de réception (S3), chaque couche de matériau semi-conducteur comprenant une succession d'éléments alignés selon une direction parallèle à l'axe, deux éléments successifs de la structure selon la direction parallèle à l'axe appartenant à deux couches différentes, les couches de matériau semi-conducteur d'au moins un ensemble de couches étant mises en contact adhérant par collage moléculaire.

2. Structure selon la revendication 1, **caractérisée en ce qu'**un premier ensemble est connecté à un deuxième ensemble par des billes de soudure (b).

3. Structure selon l'une des revendications 1 ou 2, **caractérisée en ce qu'**au moins un substrat de réception (S5) est recouvert d'au moins deux couches de matériau (K11, K12) sur une première face et d'au moins deux couches de matériau (K13, K14) sur une deuxième face.

4. Structure selon l'une quelconque des revendications 1 à 3, **caractérisée en ce qu'**elle comprend au moins un ensemble de diodes sous la forme d'une puce (BD) connectée par billes de soudure sur une face d'une couche de matériau.

5. Structure selon l'une quelconque des revendications 1 à 4, **caractérisée en ce qu'**elle comprend au moins un ensemble de diodes (D) sous la forme de diodes intégrées à une couche de matériau semi-conducteur.

6. Tête d'impression comprenant une succession de têtes magnétiques ou de résistances (t) pour réaliser une impression le long d'un axe, **caractérisée en ce qu'**elle est une structure selon l'une quelconque des revendications 1 à 5 dans laquelle un élément de la succession d'éléments est une tête magnétique ou une résistance.

7. Procédé de fabrication d'une structure comprenant une succession d'éléments (t) pour émettre ou recevoir un signal le long d'un axe, le procédé comprenant une étape d'assemblage d'au moins deux couches de matériau semi-conducteur (K1, K2) comprenant, chacune, une succession d'éléments alignés selon une direction parallèle à l'axe, l'assemblage étant effectué de façon que deux éléments successifs de la structure selon la direction parallèle à l'axe appartiennent à deux couches différentes, l'étape d'assemblage comprenant le transfert d'une deuxième couche de matériau semi-conducteur (K2) sur une première couche de matériau semi-conducteur (K1) de façon à mettre en contact adhérant par collage moléculaire une première face de la première couche (K1) avec une première face de la deuxième couche (K2).

8. Procédé selon la revendication 7, **caractérisé en ce que** le transfert de la deuxième couche de matériau (K2) sur la première couche de matériau (K1) est effectué à l'aide d'un support de transfert (T) fixé à la deuxième couche (K2).

9. Procédé selon la revendication 8, **caractérisé en ce qu'**il comprend le retrait du support de transfert (T), une fois la mise en contact adhérant effectuée.

10. Procédé selon l'une quelconque des revendications 7 à 9, **caractérisé en ce qu'**il comprend une étape de connexion, par billes de soudure, entre un premier ensemble constitué d'un premier substrat de réception (S5) sur lequel sont fixées, par collage moléculaire, au moins deux couches de matériau semi-conducteur (K11, K12) et au moins un deuxième ensemble constitué d'un deuxième substrat de réception (S3, S6) sur lequel sont fixées, par collage moléculaire, au moins deux couches de matériau semi-conducteur (K7, K8 ; K15, K16).

11. Procédé selon l'une quelconque des revendications 7 à 10, **caractérisé en ce qu'**il comprend la connexion par billes de soudure d'au moins un ensemble de diodes (BD) sur au moins une couche de matériau, chaque diode de l'ensemble de diodes permettant une commande d'un élément (t) de la couche.

12. Procédé selon l'une quelconque des revendications 7 à 11, **caractérisé en ce qu'**il comprend la formation d'au moins un ensemble de diodes (D) dans au moins une couche de matériau semi-conducteur, chaque diode de l'ensemble de diodes permettant une commande d'un élément (t) de la couche de matériau semi-conducteur.

13. Procédé de fabrication d'une tête d'impression comprenant une succession de têtes magnétiques ou de résistances (t) pour réaliser une impression le long d'un axe, **caractérisé en ce qu'**il met en oeuvre un procédé selon l'une quelconque des revendications 7 à 12 dans lequel un élément de la succession d'éléments est une tête magnétique ou une résistance.

## Claims

1. Structure comprising a sequence of elements (t) for transmitting or receiving a signal along an axis, two successive elements (t) in the direction of the axis being offset from each other along a direction perpendicular to the axis, **characterized in that** the structure comprises at least one set of at least two layers of semiconductor material (K1, K2, K3, K4) deposited on a reception substrate (S3), each layer of semiconductor material comprising a sequence of elements in line with each other in a direction parallel to the axis, two successive elements of the structure in the direction parallel to the axis belonging to two different layers, the semiconductor material layers of at least one set of layers being brought into adhesive contact by molecular bonding.

2. Structure according to claim 1, **characterized in that** a first assembly is connected to a second assembly by solder beads (b).

3. Structure according to claim 1 or 2, **characterized in that** at least one reception substrate (S5) is covered with at least two layers of material (K11, K12) on a first face and with at least two layers of material (K13, K14) on a second face.

4. Structure according to any one of the claims 1 to 3, **characterized in that** it comprises at least one set of diodes in the form of a chip (BD) connected by solder beads to a face of a material layer.

5. Structure according to any one of claims 1 to 4, **characterized in that** it comprises at least one set of diodes (D) in the form of diodes integrated into a layer of semiconductor material.

6. Print head comprising a sequence of magnetic heads or resistors (t) to print along an axis, **characterized in that** it is a structure according to any one of claims 1 to 5, in which one element of the sequence of elements is a magnetic head or a resistor.

7. Process for manufacturing a structure comprising a sequence of elements (t) for transmitting or receiving a signal along an axis, comprising a step of assembling at least two layers of semiconductor material (K1, K2) each comprising a sequence of elements aligned in a direction parallel to the axis, the assembly being made such that two successive elements of the structure in the direction parallel to the axis belong to two different layers, the assembly step comprising the transfer of a second layer of semiconductor material (K2) onto a first layer of semiconductor material (K1) to bring the first face of the first layer (K1) into adhesive contact by molecular bonding with a first face of the second layer (K2).

8. Process according to claim 7, **characterized in that** the second layer of material (K2) is transferred onto the first layer of material (K1) by means of a transfer support (T) fixed to the second layer (K2).

9. Process according to claim 8, **characterized in that** it comprises removal of the transfer support (T), once the layers have been put into adhesive contact.

10. Process according to any one of claim 7 to 9, **characterized in that** it comprises a connection step using solder beads between a first assembly composed of a first reception substrate (S5) onto which at least two layers of semiconductor material (K11, K12) are fixed by molecular bonding, and at least one second assembly composed of a second reception substrate (S3, S6), on which at least two layers of semiconductor material (K7, K8; K15, K16) are fixed by molecular bonding.

11. Process according to any one of claims 7 to 10, **characterized in that** it comprises the connection of at least a first set of diodes (BD) onto at least one material layer by solder beads, each diode in the set of diodes permitting control of one element (t) of the layer.

12. Process according to any one of claims 7 to 11, **characterized in that** it comprises the formation of at least one set of diodes (D) in at least one layer of semiconductor material, each diode in the set of diodes permitting the control of one element (t) in the layer of semiconductor material.

13. Process for manufacturing a print head comprising a sequence of magnetic heads or resistors (t) for making a printout along an axis, **characterized in that** it uses a process according to any one of claims 7 to 12, in which one element of the sequence of elements is a magnetic head or a resistor.

## Patentansprüche

1. Struktur mit einer Folge von Elementen (t), um längs einer Achse ein Signal zu senden oder zu empfangen, wobei zwei in Richtung der Achse aufeinander folgende Elemente (t) in einer zu der Achse senkrechten Richtung gegeneinander versetzt sind,
**dadurch gekennzeichnet,**
**dass** die Struktur wenigstens eine Einheit aus wenigstens zwei Halbleitermaterialschichten (K1, K2, K3, K4) umfasst, abgeschieden auf einem Aufnahmesubstrat (S3), jede Halbleitermaterialschicht eine Folge von Elementen enthält, die ausgerichtet sind entsprechend einer zu der Achse parallelen Richtung, zwei entsprechend der zu der Achse parallelen Richtung aufeinanderfolgende Elemente zu zwei verschiedenen Schichten gehören, zwischen den Halbleitermaterialschichten wenigstens einer Schichteneinheit ein Haftkontakt besteht, hergestellt durch molekulares Kleben.

2. Struktur nach Anspruch 1, **dadurch gekennzeichnet, dass** eine erste Einheit mit einer zweiten Einheit durch Lotkugeln (b) verbunden ist.

3. Struktur nach einem der Ansprüche 1 oder 2, **dadurch gekennzeichnet, dass** wenigstens ein Aufnahmesubstrat (S5) mit mindestens zwei Materialschichten (K11, K12) auf einer ersten Seite bzw. Fläche und mindestens zwei Materialschichten (K13, K14) auf einer zweiten Seite überzogen ist.

4. Struktur nach einem der Ansprüche 1 bis 3, **dadurch gekennzeichnet, dass** sie wenigstens eine Diodeneinheit in Form eines Chips (BD) umfasst, der mittels Lotkugeln auf einer Fläche einer Materialschicht befestigt ist.

5. Struktur nach einem der Ansprüche 1 bis 4, **dadurch gekennzeichnet, dass** sie wenigstens eine Diodeneinheit (D) in Form von in einer Halbleitermaterialschicht integrierten Dioden umfasst.

6. Druckkopf mit einer Folge von Magnetköpfen oder Widerständen (t), um längs einer Achse zu drucken, **dadurch gekennzeichnet, dass** sie eine Struktur nach einem der Ansprüche 1 bis 5 ist, bei der ein Element der Folge von Elementen ein Magnetkopf oder ein Widerstand ist.

7. Verfahren zur Herstellung einer Struktur mit einer Folge von Elementen (t), um ein Signal längs einer Achse zu senden oder zu empfangen, wobei dieses Verfahren einen Zusammenbauschritt von wenigstens zwei Halbleitermaterialschichten (K1, K2) umfasst, von denen jede eine Folge von Elementen enthält, die in einer zu der Achse parallelen Richtung ausgerichtet sind, wobei der Zusammenbau derart ausgeführt wird, dass zwei entsprechend der zu der Achse parallelen Richtung aufeinanderfolgende Elemente der Struktur zu zwei verschiedenen Schichten gehören und der Zusammenbauschritt den Transfer einer zweiten Halbleitermaterialschicht (K2) auf eine erste Halbleitermaterialschicht (K1) umfasst, um zwischen einer ersten Fläche der ersten Schicht (K1) und einer ersten Fläche der zweiten Schicht (K2) durch molekulares Kleben einen Haftkontakt herzustellen.

8. Verfahren nach Anspruch 7, **dadurch gekennzeichnet, dass** der Transfer der zweiten Materialschicht (K2) auf die erste Materialschicht (K1) mit Hilfe eines Transferträgers (T) erfolgt, der an der zweiten Schicht (K2) befestigt ist.

9. Verfahren nach Anspruch 8, **dadurch gekennzeichnet, dass** der Transferträger (T) entfernt wird, sobald der Haftkontakt hergestellt ist.

10. Verfahren nach einem der Ansprüche 7 bis 9, **dadurch gekennzeichnet, dass** es einen Schritt zur Herstellung einer Verbindung mittels Lotkugeln zwischen einer ersten Einheit, gebildet durch ein erstes Aufnahmesubstrat (S5), auf dem durch molekulares Kleben wenigstens zwei Halbleitermaterialschichten (K11, K12) befestigt sind, und wenigstens einer zweiten Einheit, gebildet durch ein zweites Aufnahmesubstrat (S3, S6), auf dem durch molekulares Kleben wenigstens zwei Halbleitermaterialschichten (K7, K8; K15, K16) befestigt sind, umfasst.

11. Verfahren nach einem der Ansprüche 7 bis 10, **dadurch gekennzeichnet, dass** es die Verbindung mittels Lotkugeln zwischen wenigstens einer Diodeneinheit (BD) und wenigstens einer Materialschicht umfasst, wobei jede Diodeneinheit eine Steuerung eines Elements (t) der Schicht ermöglicht.

12. Verfahren nach einem der Ansprüche 7 bis 11, **dadurch gekennzeichnet, dass** es die Bildung wenigstens einer Diodeneinheit (D) in wenigstens einer Halbleitermaterialschicht umfasst, wobei jede Diodeneinheit eine Steuerung eines Elements (t) der Halbleitermaterialschicht ermöglicht.

13. Herstellungsverfahren eines Druckkopfes mit einer Folge von Magnetköpfen oder Widerständen (t), um längs einer Achse zu drucken, **dadurch gekennzeichnet, dass** es ein Verfahren nach einem der Ansprüche 7 bis 12 umfasst, in dem ein Element der Folge von Elementen ein Magnetkopf oder ein Widerstand ist.
